# EUROPÄISCHE PATENTSCHRIFT

(11) **EP 0 827 680 B1**
(45) Veröffentlichungstag und Bekanntmachung des Hinweises auf die Patenterteilung: **10.05.2000**
(21) Anmeldenummer: 96903897.5
(22) Anmeldetag: 24.02.1996
(51) Int. Cl.: H05B 33/26, H05B 33/28

(54) **ELEKTROLUMINESZIERENDES SCHICHTSYSTEM**
ELECTROLUMINESCENT LAYER SYSTEM
SYSTEME MULTICOUCHE ELECTROLUMINESCENT

(30) Priorität: 22.05.1995 DE 19518668
(43) Veröffentlichungstag der Anmeldung: 11.03.1998
(73) Patentinhaber: ROBERT BOSCH GMBH, 70442 Stuttgart (DE)
(72) Erfinder: GROTHE, Wolfgang, D-75233 Tiefenbronn (DE); GRÜNWALD, Werner, D-70839 Gerlingen (DE); HÜPPAUFF, Martin, D-70563 Stuttgart (DE); SCHMIDT, Claus, D-71106 Magstadt (DE); FENSKE, Dieter, D-76275 Ettlingen (DE); SCHMID, Günter, D-42555 Velbert (DE)
(86) Internationale Anmeldenummer: DE9600309
(87) Internationale Veröffentlichungsnummer: WO9638023

(56) Entgegenhaltungen:
- COLLOID & POLYMER SCIENCE, FEB. 1995, GERMANY, Bd. 273, Nr. 2, ISSN 0303-402X, Seiten 101-117, XP002003112 SCHOEN G ET AL: "A fascinating new field in colloid science: small ligand-stabilized metal clusters and possible application in microelectronics. 1. State of the art"

## Beschreibung

Die Erfindung betrifft ein elektrolumineszierendes Schichtsystem nach dem Oberbegriff des Anspruchs 1.

### Stand der Technik

Elektrolumineszierende Schichtsysteme sind bekannt. In diesen werden entweder anorganische oder organische Substanzen verwendet, die mittels einer elektrischen Spannung zum Aussenden von Lichtstrahlen anregbar sind. Die lichtemittierenden Substanzen sind hierbei beispielsweise zwischen flächenhaften Elektroden angeordnet, wobei eine erste Elektrode als löcherinjizierende Elektrode und eine zweite Elektrode als elektroneninjizierende Elektrode ausgebildet ist. Wird die lichtemittierende Substanz von einem organischen Material gebildet, kann die Anregung über eine Gleichspannungsquelle erfolgen. Hierbei ist die löcherinjizierende Elektrode mit dem Pluspol der Gleichspannungsquelle und die elektroneninjizierende Elektrode mit dem Minuspol der Gleichspannungsquelle verbunden. Ein derartiges elektrolumineszierendes Schichtsystem ist beispielsweise aus der EP 0 281 381 bekannt. Hier besteht die löcherinjizierende Elektrode aus einem Metall oder einer elektrisch leitfähigen, optisch transparenten, oxidischen Verbindung mit hoher Elektronenaustrittsarbeit von größer als 4,5 eV. Die elektroneninjizierende Elektrode besteht aus einem von einem Alkalimetall verschiedenen Metall und besitzt eine niedrige Elektronenaustrittsarbeit. Hierbei ist nachteilig, daß durch auf die aufeinander abgestimmte Auswahl der Materialien der Elektroden, nämlich eine löcherinjizierende Elektrode und eine elektroneninjizierende Elektrode, nur sehr begrenzte Kombinationsmöglichkeiten bestehen.

### Vorteile der Erfindung

Das erfindungsgemäße elektrolumineszierende Schichtsystem mit den im Anspruch 1 genannten Merkmalen bietet den Vorteil, daß die Eigenschaften der löcherinjizierenden und/oder elektroneninjizierenden Elektrode in einfacher Weise an den spezifischen Anforderungen des elektrolumineszierenden Schichtsystems anpaßbar sind. Dadurch, daß die löcherinjizierende Elektrode und/oder die elektroneninjizierende Elektrode aus einem Nanomaterial (Material mit einer mittleren Teilchengröße im nm-Bereich) besteht, läßt sich über die Eigenschaften und die Dimensionierung des Nanomaterials eine gewünschte niedrige oder hohe Elektronenaustrittsarbeit einstellen. Die Nanomaterialien können somit in einfacher Weise an die Erfordernisse einer löcherinjizierenden oder elektroneninjizierenden Elektrode angepaßt werden.

In vorteilhafter Ausgestaltung der Erfindung ist vorgesehen, daß die Nanomaterialien von in einer Matrix eingebetteten Clustern gebildet werden, die vorzugsweise von organischen Ligandenhüllen umgeben sind. Hierbei ist es vorteilhaft möglich, über die Ligandenhüllen die Cluster zu stabilisieren und somit die löcherinjizierende Elektrode und/oder die elektroneninjizierende Elektrode korrosionsbeständig auszubilden. Über die Dimensionierung der Cluster ist die Elektronenaustrittsarbeit der jeweiligen Elektrode einstellbar.

Weitere vorteilhafte Ausgestaltungen ergeben sich aus den übrigen in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: eine schematische Schnittdarstellung durch ein elektrolumineszierendes System und
- Figur 2: eine schematische Schnittdarstellung durch ein elektrolumineszierendes System nach einer weiteren Ausführung.

### Beschreibung der Ausführungsbeispiele

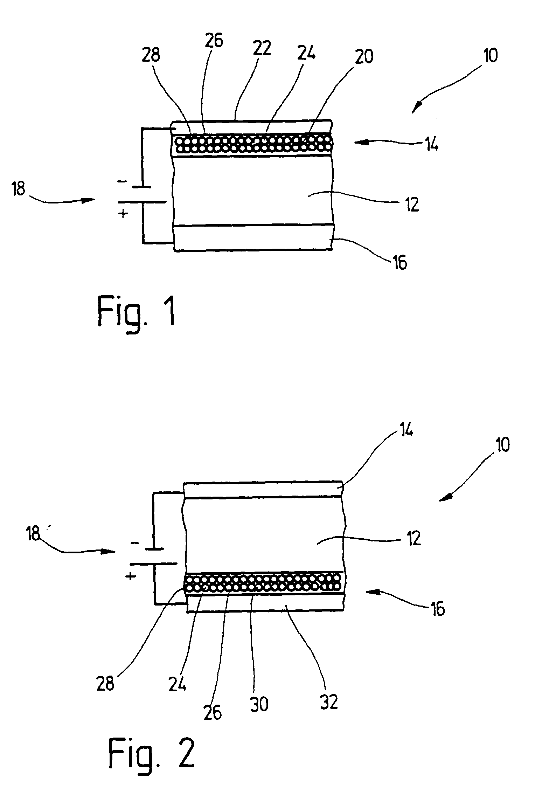

Figur 1 zeigt ein elektrolumineszierendes Schichtsystem 10. Die Darstellung zeigt ausschnittsweise schematisch einen Schnitt durch das Schichtsystem 10. Das Schichtsystem 10 besitzt ein lichtemittierendes Material 12, das zwischen einer ersten Elektrode 14 und einer zweiten Elektrode 16 angeordnet ist. Die Elektroden 14 und 16 sind flächenhaft ausgebildet, so daß das sich zwischen den Elektroden 14 und 16 befindliche lichtemittierende Material 12 ebenfalls flächig ausgebildet ist. Die Elektroden 14 und 16 sind mit einer Spannungsquelle 18, beispielsweise einer Gleichspannungsquelle, insbesondere einer Batterie eines Kraftfahrzeuges, verbunden. Die Elektrode 14 ist hierbei mit dem Minuspol der Spannungsquelle 18 beziehungsweise Masse und die Elektrode 16 mit dem Pluspol der Spannungsquelle 18 verbunden.

Das lichtemittierende Material 12 besitzt wenigstens eine organische Substanz, die unter Anlegen der Spannung in der Lage ist, Licht zu emittieren. Die Farbe des emittierten Lichtes wird hierbei durch die chemische Struktur der verwendeten organischen Substanz bestimmt. Als lichtemittierende organische Substanzen kommen beispielsweise Polymere, niedermolekulare organische Verbindungen, Monomere oder molekulardotierte Polymere in Betracht.

Zwischen den Elektroden 14 und 16 können weitere, hier nicht dargestellte, Schichten angeordnet sein, die ebenfalls zur Lichtemission oder zu einem Ladungsträgertransport zu dem lichtemittierenden Material 12 dienen.

Die Elektrode 16 besteht aus einem löcherinjizierenden Material, beispielsweise Indium-Zinnoxid. Indium-Zinnoxid-Elektroden sind allgemein bekannt und weisen eine hohe Elektronenaustrittsarbeit auf. Die Elektrode 16 ist darüber hinaus optisch transparent, so daß mittels des organischen Materials 12 emittiertes Licht von dem Schichtsystem 10 abgestrahlt werden kann.

Die Elektrode 14 besitzt eine elektroneninjizierende Schicht 20 und eine auf die Schicht 20 aufgebrachte Kontaktierung 22. Die Kontaktierung 22 kann beispielsweise von auf der Schicht 20 aufgedampften Aluminium gebildet werden. Die elektroneninjizierende Schicht 20 besteht aus einzelnen Clustern 24, die in eine Matrix 26 eingebettet sind und über organische Ligandenhüllen 28 miteinander verbunden sind. Als Cluster 24 können beispielsweise Übergangsmetallchalcogenid-Cluster verwendet werden. Die Cluster 24 sind hierbei so dimensioniert, daß diese bestimmte elektronische und mechanische Eigenschaften aufweisen. Im Beispiel sind die Cluster 24 derart dimensioniert, daß diese eine niedrige Elektronenaustrittsarbeit beziehungsweise niedrige Elektronenaffinität aufweisen. Die organischen Ligandenhüllen 28 stabilisieren die Cluster 24 in der Matrix 26. Durch die organische Ligandenhülle wird die Positionierung der Cluster 24 innerhalb der elektroneninjizierenden Schicht bestimmt, da die Ligandenhüllen untereinander eine chemische Verbindung eingehen, die die mechanische Stabilität der Schicht 20 und damit die Lage der Cluster 24 bestimmt. Durch die Wahl einer Dicke der Ligandenhülle sind die Abstände der Cluster 24 zueinander einstellbar. Die Dicke der Ligandenhülle 28 ist so gewählt, daß die Elektronenleitung durch die Schicht 20 gewährleistet ist, wobei die Elektronen durch die Ligandenhüllen tunneln. Die Ligandenhüllen aus organischen Substanzen besitzen eine hohe Beweglichkeit für Löcher, so daß diese sich innerhalb der Ligandenhülle bewegen können. Diese sich hieraus ergebende Tunnelleitfähigkeit gewährleistet die elektroneninjizierende Wirkung der Elektrode 14. Die Cluster 24 liegen im Nanobereich vor, während die Ligandenhüllen 28 in der Regel wenige Atomlagen stark sind. Durch die geringe Korngröße der Cluster 24 im Nanobereich besitzt die elektroneninjizierende Schicht 20 einen hohen Füllgrad (Packungsdichte), so daß eine Vielzahl von chemischen Verbindungen zwischen den Ligandenhüllen 28 bestehen. Hierdurch ist eine große mechanische Stabilität der Schicht 20 gegeben.

In der Figur 2 ist ein weiteres Ausführungsbeispiel gezeigt, wobei gleiche Teile wie in Figur 1 mit gleichen Bezugszeichen versehen und nicht nochmals erläutert sind. Gegenüber dem in Figur 1 gezeigten Ausführungsbeispiel besitzt hier die Elektrode 16 eine löcherinjizierende Schicht 30, die mit einer Kontaktierung 32 versehen ist. Die Kontaktierung 32 kann beispielsweise aus Indium-Zinnoxid bestehen. Die Schicht 30 besteht wiederum aus Clustern 24, die in einer Matrix 26 angeordnet sind und über organische Ligandenhüllen 28 stabilisiert sind. Der Aufbau und die Wirkungsweise der Schicht 30 entspricht dem beispielsweise zu der Schicht 20 Dargelegtem. Die Cluster 24 und/oder Ligandenhüllen 28 sind hier jedoch so dimensioniert, daß anstelle der elektroneninjizierenden Schicht 20 eine löcherinjizierende Schicht 30 gebildet ist, das heißt, die Schicht 30 eine hohe Elektronenaustrittsarbeit beziehungsweise Elektronenaffinität aufweist.

Nach einem weiteren, nicht dargestellten Ausführungsbeispiel, kann ein elektrolumineszierendes Schichtsystem 10 sowohl eine elektroneninjizierende Elektrode 14 mit einer Schicht 20 und eine löcherinjizierende Elektrode 16 mit einer Schicht 30 aufweisen. Beide Elektroden 14 und 16, beziehungsweise die Schichten 20 und 30, besitzen hierbei über organische Ligandenhüllen stabilisierte Cluster. Die Cluster können aus einem gleichen Material bestehen, besitzen lediglich eine unterschiedliche Dimensionierung und damit eine unterschiedliche elektronische Eigenschaft. Durch die Variationsmöglichkeiten der elektronischen Eigenschaften der Nanomaterialien über deren mikroskopische Dimension und deren Zusammensetzung kann die Elektronenaustrittsarbeit der Elektroden 14 und 16 den Energieniveaus des lichtemittierenden Materials 12, insbesondere deren Leitungsband beziehungsweise Valenzband, optimal angepaßt werden. Eine Barrierenhöhe zwischen der Elektrode 14 beziehungsweise der Elektrode 16 und dem lichtemittierenden Material 12 für Elektronen beziehungsweise Löcher kann so bis gegen Null minimiert werden. Letztendlich ist es also möglich, mittels einer Auswahl der Cluster 24 und der organischen Ligandenhüllen 28 in einfacher Weise sowohl die löcherinjizierende Elektrode 16 als auch die elektroneninjizierende Elektrode 14, insbesondere deren Elektronenaustrittsarbeit, zu definieren.

Als Nanomaterialien, das heißt, als Cluster 24, liegen beispielsweise ligandenstabilisierte Gold-, Platin-, Palladium-, Gold/Platin-, Gold/Palladium-Cluster und Chalcogenid-Cluster (die Übergangsmetalle Titan, Vanadium, Mangan, Eisen, Kobalt, Nickel, Kupfer, Zink, Zirkon, Niob, Rhodium, Palladium, Silber, Kadmium, Tantal, Iridium, Platin, Quecksilber verknüpft mit den Hauptgruppenelementen Phosphor, Arsen, Antimon, Schwefel, Selen, Tellur) vor.

## Patentansprüche

1. Elektrolumineszierendes Schichtsystem mit einem zwischen zwei mit einer Gleichspannungsquelle verbindbaren Elektroden angeordneten lichtemittierenden organischen Material, wobei eine erste Elektrode eine löcherinjizierende Elektrode (Anode) und eine zweite Elektrode eine elektroneninjizierende Elektrode (Kathode) ist, **dadurch gekennzeichnet,** daß die löcherinjizierende Elektrode (16) und/oder die elektroneninjizierende Elektrode (14) zumindest bereichsweise von in einer Matrix (26) eingebetteten Clustern (24) gebildet ist, die eine mittlere Teilchengröße im Nanometer-Bereich aufweisen.

2. Elektrolumineszierendes Schichtsystem nach Anspruch 1, **dadurch gekennzeichnet,** daß die Cluster (24) über organische Abstandshalter miteinander verbunden sind.

3. Elektrolumineszierendes Schichtsystem nach Anspruch 3, **dadurch gekennzeichnet,** daß die organischen Abstandshalter von organischen Ligandenhüllen (28) gebildet werden.

4. Elektrolumineszierendes Schichtsystem nach einem der vorhergehenden Ansprüche, **dadurch gekennzeichnet,** daß die elektroneninjizierende Elektrode (14) aus einer die Cluster (24) aufweisenden, elektroneninjizierenden Schicht (20) und einer Kontaktierung (22) besteht.

5. Elektrolumineszierendes Schichtsystem nach einem der vorhergehenden Ansprüche, **dadurch gekennzeichnet,** daß die löcherinjizierende Elektrode (16) aus einer die Cluster (24) aufweisenden, löcherinjizierenden Schicht (30) und einer Kontaktierung (32) besteht.

## Claims

1. Electroluminescent layer system having a light-emitting organic material arranged between two electrodes that can be connected to a DC voltage source, a first electrode being a hole-injecting electrode (anode) and a second electrode being an electron-injecting electrode (cathode), characterized in that the hole-injecting electrode (16) and/or the electron-injecting electrode (14) is at least locally formed by clusters (24) which are embedded in a matrix (26) and have an average particle size in the nanometer range.

2. Electroluminescent layer system according to Claim 1, characterized in that the clusters (24) are connected to one another via organic spacers.

3. Electroluminescent layer system according to Claim 2, characterized in that the organic spacers are formed by organic ligand shells (28).

4. Electroluminescent layer system according to one of the preceding claims, characterized in that the electron-injecting electrode (14) consists of an electron-injecting layer (20) comprising the clusters (24) and a contact (22).

5. Electroluminescent layer system according to one of the preceding claims, characterized in that the hole-injecting electrode (16) consists of a hole-injecting layer (30) which comprises the clusters (24) and a contact (32).

## Revendications

1. Système multicouche électroluminescent comprenant de la matière organique photoémissive entre deux électrodes susceptibles d'être reliées à une source de tension continue, la première électrode étant une électrode injectant des trous (anode) et la seconde électrode étant une électrode injectant des électrons (cathode)
caractérisé en ce que
l'électrode injectant les trous (16) et/ou l'électrode injectant les électrons (14) sont formées, au moins par zones, par des complexes (24) intégrés dans une matrice (26), ces complexes ayant une granulométrie moyenne du domaine nanométrique.

2. Système multicouche électroluminescent selon la revendication 1,
caractérisé en ce que
les complexes (24) sont reliés par un moyen d'écartement organique.

3. Système multicouche électroluminescent selon la revendication 2,
caractérisé en ce que
le moyen d'écartement organique est formé par des enveloppes de ligands organiques (28).

4. Système multicouche électroluminescent selon l'une des revendications précédentes,
caractérisé en ce que
l'électrode injectant les électrons (14) est formée d'une couche d'injection d'électrons (20) comprenant les complexes (24), et d'un contact (22).

5. Système multicouche électroluminescent selon l'une quelconque des revendications précédentes,
caractérisé en ce que
l'électrode injectant les trous (16) est formée d'une couche (30) d'injection de trous comprenant les complexes (24), et d'un contact (32).
